(19) Europäisches Patentamt
European Patent Office
Office européen des brevets

(11) Numéro de publication: **0 188 145**
**B1**

(12) # FASCICULE DE BREVET EUROPÉEN

(45) Date de publication du fascicule du brevet: **31.05.89**

(51) Int. Cl.⁴: **G 01 N 24/08**

(21) Numéro de dépôt: **85402373.6**

(22) Date de dépôt: **02.12.85**

(54) **Procédé de génération et de traitement de signaux pour l'obtention par résonance magnétique nucléaire d'une image exempte de distorsions à partir d'un champ de polarisation inhomogène.**

(30) Priorité: **12.12.84 FR 8418997**

(43) Date de publication de la demande:
**23.07.86 Bulletin 86/30**

(45) Mention de la délivrance du brevet:
**31.05.89 Bulletin 89/22**

(84) Etats contractants désignés:
**CH DE GB IT LI NL SE**

(56) Documents cité:
**EP-A-0 123 200**
**GB-A-2 079 946**

**JOURNAL OF PHYSICS E: SCIENTIFIC INSTRUMENTS, vol. 15, no. 10, octobre 1982, pages 1093-1100, The Institute of Physics, Dorking, GB; C.-M. LAI: "Reconstructing NMR images under magnetic fields with large inhomogeneities"**
**PHYSICS IN MEDICINE & BIOLOGY, vol. 29, no. 1, janvier 1984, pages 15-24, The Institute of Physics, Bristol, GB; K. SEKIHARA et al.: "Image restoration from non-uniform magnetic field influence for direct Fourier NMR imaging"**
**PROCEEDINGS OF THE IEEE, vol. 70, no. 10, octobre 1982, pages 1152-1173, IEEE, New York, US; Z.H. CHO et al.: "Fourier transform nuclear magnetic resonance tomographic imaging"**

(73) Titulaire: **COMMISSARIAT A L'ENERGIE ATOMIQUE, 31/33, rue de la Fédération, F-75015 Paris (FR)**

(72) Inventeur: **Briguet, André, 14 avenue Condorcet, F-69100 Villeurbanne (FR)**
Inventeur: **Goldman, Maurice, 5, Square Yves du Manoir, F-91300 Massy (FR)**

(74) Mandataire: **Mongrédien, André, c/o BREVATOME 25, rue de Ponthieu, F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

**EP 0 188 145 B1**

LIBER, STOCKHOLM 1989

## Description

La présente invention se rapporte aux techniques d'imagerie par la méthode dite de résonance magnétique nucléaire (RMN) actuellement en voie de développement rapide, notamment pour l'examen du corps humain, dont elle permet d'obtenir des images d'une qualité et d'une précision inconnues jusqu'ici avec les méthodes de la radiologie classique aux rayons X. Elle s'applique à la phase de construction de l'image obtenue par codage spatial et calcul à l'aide d'un ordinateur.

La méthode d'imagerie RMN utilise la propriété de résonance magnétique nucléaire de certains noyaux présents dans le corps humain, essentiellement les protons répartis dans tout l'organisme, et quelques noyaux d'intérêt biologique mais en abondance beaucoup moins grande tels que le phosphore $^{31}P$, le potassium $^{39}K$, le sodium $^{23}Na$. Elle permet, en dressant la carte de leur concentration en chaque point du volume examiné, de fabriquer des images des tissus vivants, notamment à partir de l'hydrogène contenu dans l'eau et les lipides qui sont deux composants essentiels de toute matière vivante.

Une installation de RMN médicale se compose principalement d'un aimant destiné à produire dans toute la zone du corps à examiner un champ magnétique de polarisation Bo, statique et uniforme, auquel on superpose, à l'aide d'une bobine auxiliaire, des impulsions de champ de radiofréquence dans un plan perpendiculaire à la direction du champ Bo précédent.

Les images sont obtenues en faisant résonner le plus souvent des noyaux d'hydrogène ou protons, contenus dans les tissus biologiques. Cette résonance est possible parce que chaque proton se comporte comme un microscopique aimant, et que le champ de radiofréquence est équivalent à deux champs tournant en sens inverse dont celui qui tourne dans le sens de précession des spins est susceptible de se coupler avec eux. Lorsque l'on applique le champ statique $\overrightarrow{Bo}$, les spins s'orientent tous parallèlement à l'axe du champ. Ils n'ont donc plus que deux orientations possibles: dans le sens du champ ou en sens contraire. Lorsqu'on applique en plus le champ de radiofréquence à une fréquence quelconque, il ne se passe rien. Mais si cette fréquence est choisie égale ou très voisine de $f_o$ (fréquence de Larmor), telle que $2\pi f_o = \gamma B_o$, formule dans laquelle $\gamma$ est une constante physique caractéristique des noyaux que l'on veut mettre en résonance et dénommée rapport gyromagnétique, le couplage des spins et du champ tournant atteint une valeur telle que ceux-ci entrent en résonance.

Le signal de résonance détecté au cours de leur retour à l'équilibre en précession libre est proportionnel à l'aimantation $\overrightarrow{M}$ des noyaux placés dans le champ magnétique $\overrightarrow{Bo}$ de polarisation. L'observation du phénomène de résonance requiert la présence d'un champ magnétique élevé (de 0,1 à 1 tesla) et de très grande uniformité dans tout le volume à imager.

On rappellera maintenant un certain nombre de phénomènes connus et l'on fixera un certain nombre de conventions qui aideront à la compréhension de la suite du présent texte.

Tout d'abord on repèrera le volume à imager par rapport à un trièdre trirectangle O, x, y, z dans lequel l'axe Oz sera, par convention, parallèle au champ continu de polarisation $\overrightarrow{Bo}$. Dans cette hypothèse, le vecteur aimantation macroscopique $\overrightarrow{M}$ du milieu à imager sera, au repos, parallèle à cet axe Oz et le champ de radiofréquence $B_1$, tournant à la vitesse angulaire $\omega_o$ sera situé dans le plan x,o,y qui est également celui dans lequel on recueille le signal de résonance.

Pour décrire ces divers phénomènes, on a souvent recours à un référentiel x', O, y', z tournant autour de Oz à la pulsation $\omega_o$ (Fig. 1 et 2). Dans ce référentiel, $\overrightarrow{B_1}$ est aligné sur Ox'.

Une impulsion de radiofréquence à la fréquence de Larmor $f_o$ dirigée selon l'axe Ox' a la propriété de faire tourner le vecteur aimantation macroscopique $\overrightarrow{M}$ d'un angle $\theta$ autour de Ox dans le plan y'Oz tel que

$$\theta = \gamma B_1 t,$$

formule dans laquelle
$\gamma$ est le rapport gyromagnétique,
$B_1$ le module du champ de radiofréquence et
t la durée d'application de ce champ.

Dans les techniques de RMN, on utilise surtout les impulsions dans lesquelles $\theta = 90°$ et $\theta = 180°$ dites respectivement impulsion à 90° et impulsion à 180°. Ces deux types d'impulsion ont respectivement les propriétés suivantes.

Les impulsions de 90° selon Ox' font basculer le vecteur $\overrightarrow{M}$ selon l'axe Oy' comme on le voit sur la Fig. 1. A partir de cette position initiale, le vecteur M se met à précesser dans le plan xoy, également à la pulsation $\omega_o = 2\pi fo$ comme $\overrightarrow{B_1}$ et c'est ce mouvement qui induit précisément le signal de résonance à la fréquence de Larmor que l'on détecte à l'aide d'une bobine non représentée placée dans ce même plan xOy.

Au moment de l'application selon Ox' d'une impulsion à 90°, tous les moments magnétiques des différents noyaux sont mis en phase selon Oy' et le vecteur $\overrightarrow{M}$ a son module maximal M selon Oy'. Au fur et à mesure de l'écoulement du temps, une dispersion des moments magnétiques selon par exemple deux camposantes $M_1$ et $M_2$ tournant en sens inverse dans le plan x'Oy' par rapport à Oz se produit sous la double influence de l'inhomogénéité du champ $B = B_o + E\ (x,y,z)$ et des interactions entre noyaux. C'est le phénomène de la relaxation transverse qui conduit le moment résultant M à décroître avec une constante de temps $T_2$ de façon telle que $|\overrightarrow{M}| = M.e^{-t/T_2}$ et le signal de résonance à s'éteindre.

Les impulsions de 180° ont la double propriété de réaliser une inversion de population des spins en plaçant

le vecteur aimantation macroscopique Mo dans sa position antiparallèle et d'effectuer une transformation symétrique par rapport à la direction de cette impulsion, à la manière de l'image dans un miroir plan, des vecteurs aimantation existant au moment de l'impulsion. Ceci équivaut par conséquent, dans le cas où l'impulsion de radiofréquence à 180° est dirigée selon Oy', à changer en - Ø les phases Ø des vecteurs $M_1$ et $M_2$ qui s'échangent alors mutuellement, et à changer Ø en (π - Ø) dans le cas où cette impulsion à 180° serait dirigée comme $B_1$ selon Ox', $\overrightarrow{M_1}$ et $\overrightarrow{M_2}$ prenant alors les places de $\overrightarrow{M_3}$ et $\overrightarrow{M_4}$.

Les différentes considérations précédentes ayant été exposées, on expliquera maintenant les techniques connues pour obtenir par le calcul une image de RMN d'un organisme vivant. Si le champ continu de polarisation $\overrightarrow{Bo}$ est parfaitement homogène, tous les vecteurs aimantation $\overrightarrow{M}$ issus des différents points du volume à imager sont en phase et il est impossible, dans le signal global reçu:

$$s(t) = \iiint_{xyz} M(x,y,z)\, e^{-t/T_2}\, dx\, dy\, dz$$

d'attribuer à chaque point une fréquence et une intensité particulières. Pour parvenir à identifier la contribution à ce signal global de chaque volume élémentaire, on réalise un codage en fréquence de l'espace à imager, en superposant au champ Bo des champs additionnels variant linéairement suivant l'une des coordonnées, de sorte que la composante Bz a des gradients spatiaux

$$\frac{\partial B_z}{\partial x}, \frac{\partial B_z}{\partial y} \text{ et } \frac{\partial B_z}{\partial z}$$

constants selon x, y et z, satisfaisant les trois égalités suivantes:

$$B_{z(x)} = \frac{\partial B_z}{\partial x} \cdot x = G_x \cdot x$$
$$B_{z(y)} = \frac{\partial B_z}{\partial y} \cdot y = G_y \cdot y$$
$$B_{z(z)} = \frac{\partial B_z}{\partial z} \cdot z = G_z \cdot z$$

dans lesquelles

$B_o + B_z$ est la composante du champ continu de polarisation suivant Oz et

Gx, Gy, Gz les trois gradients constants de l'induction résultante selon Ox, Oy et Oz.

L'usage a prévalu en imagerie par RMN d'appeler, de façon impropre, ces champs additionnels "gradients linéaires" ("linear gradients") et nous nous conformerons à cet usage dans la suite du présent texte.

On comprend facilement le but recherché à l'aide de ces gradients linéaires: la fréquence ou pulsation de Larmor $\omega = \gamma B$ étant, en tout point du volume à imager, proportionnelle à l'induction en ce point, on réalise ainsi un codage spatial de ce volume en phase et en fréquence et on peut montrer que la transformée de Fourier du signal temporel s(t) ou spectre de fréquences s(ω) de ce même signal est l'image tridimensionnelle elle-même de l'échantillon en densité d'aimantation puisqu'en présence d'un gradient linéaire la fréquence représente la coordonnée selon laquelle est appliqué ce gradient. A titre illustratif, la Fig. 3 montre la répartition des vecteurs $B_z$ dans le cas d'un gradient linéaire $G_x$ selon la direction Ox. C'est la méthode de construction de l'image dite méthode de Fourier directe; elle s'applique aussi bien d'ailleurs à l'imagerie tridimensionnelle (en anglais "3D, FT") que bidimensionnelle (en anglais "2D, FT") et on en rappellera maintenant de façon succincte le principe, car c'est à cette méthode d'imagerie que s'applique spécialement bien l'invention.

Méthode de Fourier directe à trois dimensions (3D, FT)

On a représenté sur la Fig. 4 l'évolution dans le temps représenté en abscisses des différents champs appliqués au volume à imager et du signal de résonance magnétique des protons reçu.

Le graphe 1 montre l'impulsion de radiofréquence à 90° qui déclenche une séquence d'analyse du volume à imager en déclenchant le processus de relaxation transverse de l'aimantation M et son mouvement de précession libre à la fréquence de Larmor autour de la direction Oz parallèle au champ continu Bo de polarisation. Pendant un temps τ suivant cette impulsion, on applique comme représenté sur les graphes 2 et 3 les gradients linéaires $G_z$ et $G_y$ qui réalisent un codage en phase dans ces deux directions en chaque point du volume, les déphasages ainsi acquis par l'aimantation M(x,y,z) pouvant s'écrire en notation complexe

$$e^{i\gamma G_z \cdot z \cdot \tau} \text{ et } e^{i\gamma G_y \cdot y \cdot \tau}.$$

Pratiquement d'ailleurs, les différents gradients $G_z$ et $G_y$ sont appliqués par valeurs croissantes de -G à +G et, pour chaque valeur d'un gradient $G_z$ on applique successivement tous les gradients $G_y$ de $-G_y$ à $+G_y$, ce qui donne si N et N' sont les nombres respectifs de gradients $G_z$ et $G_y$ appliqués, un nombre de mesures égal à N x N'.

A la fin de chaque codage de phase en z et en y, on applique pendant un temps $\tau_x$ le gradient $G_x$ ou gradient de lecture, comme représenté sur le graphe 4 et l'on recueille alors le signal de résonance représenté sur le graphe 5. Ce signal, en supposant le champ de polarisation homogène, est de la forme:

$$s(t) = \iiint_{xyz} M(x,y,z)\, e^{-t/T_2} \cdot e^{i\gamma G_y \cdot y \cdot \tau} \cdot e^{i\gamma G_z \cdot z \cdot \tau} \cdot e^{i\gamma G_x \cdot x \cdot t} \cdot dx \cdot dy \cdot dz$$

formule dans laquelle les deux premières exponentielles représentent les déphasages acquis par les vecteurs

aimantations $\vec{M}$ pendant le codage de phase et la troisième le déphasage acquis pendant l'acquisition du signal.

C'est sur ce signal s(t) que l'on effectue ensuite, dans un ordre quelconque les trois transformées de Fourier par rapport à $G_z$ à $G_y$ et au temps t pour obtenir, de façon connue, à l'aide d'un calculateur, la répartition spatiale de l'aimantation des différents points du volume à imager sous forme d'une image complexe tridimensionnelle, comportant un volume "réel" et un volume "imaginaire".

Méthode de Fourier directe à deux dimensions (2D, FT):

On a représenté sur la Fig. 5 l'évolution dans le temps, représenté en abscisses, des mêmes grandeurs que sur la Fig. 4, à l'aide des mêmes graphes 1, 2, 3, 4, 5.

Dans cette méthode toutefois, on utilise le premier gradient $G_z$ pour définir, dans le volume à imager, une coupe ou tranche, perpendiculaire à Oz, d'épaisseur

$$\Delta = 2\pi/\gamma G_z \tau_z$$

centrée sur la cote

$$zo = (2\pi fo - \gamma B)G_z$$

et dans laquelle on travaille ensuite selon les deux coordonnées x et y. Cette coupe sélective est obtenue en associant pendant le temps $\tau_z$ (Fig. 5) une impulsion de radiofréquence 90°, RF, à la fréquence moyenne fo et le gradient linéaire

$$Gz = \frac{\partial B_z}{\partial z}$$

comme le montrent les graphes 1 et 2.

Ensuite interviennent, comme dans la méthode tridimensionnelle, une période de codage de phase avec le gradient Gy de durée $\tau_y$ et une période de codage en fréquences avec le gradient Gx de durée $\tau_x$, pendant laquelle on effectue également l'acquisition du signal

$$s(t) = \iint_{xy} M(x,y)\, e^{-t/T_2}\, e^{i\gamma G y \cdot y \cdot \tau_y} \cdot e^{i\gamma G x \cdot x \cdot t}\, dx \cdot dy$$

où les deux exponentielles représentent les déphasages acquis pendant le codage de phase et le codage de fréquence par les différents vecteurs aimantations M de la tranche examinée.

Les deux transformations de Fourier par rapport à $G_y$ et par rapport au temps t interviennent ensuite et permettent d'obtenir un signal analytique complexe comportant une image "réelle" et une image "imaginaire" de la répartition spatiale de l'aimantation dans la tranche sélectionnée, et, par là-même, une image tomographique de cette même tranche.

La théorie complète des principes de la résonance magnétique nucléaire et de son application à l'imagerie médicale sont notamment décrites dans les ouvrages suivants: Shaw, D., Fourier Transform NMR Spectroscopy, Elsevier, Amsterdam, 1976; Farrar, T.C. and Becker, E.C., Pulse and Fourier Transform NMR, Academic Press, 1971; Abragam, A., The Principles of Nuclear Magnetism, Oxford University Press (Clarendon), London, 1961; Mansfield, P. and Morris, P.G., NMR Imaging in Biomedicine, Academic Press, 1982; Kaufman, L., Crooks, L.E. and Margulis, A.R., Nuclear Magnetic Resonance Imaging in Medicine Igaku-Shoin, New-York, Tokyo, 1981, Chapters 1 and 2.

La théorie connue de l'imagerie RMN qui vient d'être rappelée brièvement suppose toutefois une homogénéité parfaite du champ de polarisation Bo appliqué, ce qui, dans la pratique, n'est jamais réalisé complètement et conduit à des défauts graves et coûteux pour les installations de RMN réalisées à ce jour.

En effet, si l'on représente le champ de polarisation par la fonction

$$B(x,y,z) = Bo + E(x,y,z)$$

dans laquelle E(x,y,z) représente l'inhomogénéité du champ au point (x,y,z) par rapport à Bo souhaité, on doit compléter l'écriture précédente du signal s(t) reçu par deux exponentielles en facteur avec les précédentes et qui s'écrivent: $e^{i\gamma E(x,y,z)\tau} \cdot e^{i\gamma E(x,y,z)t}$ pour tenir compte des phases acquises par les différents vecteurs aimantation, dues à l'inhomogénéité du champ, durant les périodes de codage de phase et de codage de fréquence respectivement. La première de ces deux exponentielles est une constante qui se conserve en l'état après le codage de phase, mais la seconde est, malheureusement à la fois une fonction de x, y, z et du temps t. Elle conduit, quand on utilise les transformées de Fourier, à des distorsions stigmatiques aggravées d'un brouillage de l'information des images "réelle" et "imaginaire" qui mélange les termes d'absorption et de dispersion et rend ces défauts non corrigibles si l'on ne connait pas, à l'avance, la fonction E(x,y,z) et la carte du champ. Ces défauts se traduisent, lors de la reconstruction de l'image par ordinateur, par une affectation spatiale erronée de l'intensité d'aimantation de chaque volume élémentaire constituant l'échantillon Ces distorsions stigmatiques conduisent à des déformations importantes de l'image et sont surtout gênantes lorsque l'on fait de la microimagerie et que l'on veut représenter des détails très fins.

Par ailleurs, l'inhomogénéité du champ en RMN affecte également la sensibilité des mesures (rapport signal/bruit). En effet, si l'inhomogénéité de B se traduit sur le volume de l'échantillon par une dispersion $\Delta B$, la limite de résolution spatiale est approximativement $\Delta B/G$ en présence d'un gradient G. La limite de résolution étant fixée, la dimension de l'échantillon étant donnée, l'intervalle spectral sur lequel s'étalent les signaux de résonance est d'autant plus élevé que $\Delta B$ est importante. L'énergie du signal par intervalle spectral en est d'autant plus faible et le travail en champ inhomogène est mauvais pour la sensibilité.

On peut évidemment chercher à réaliser des aimants perfectionnés dont le champ soit homogène à un haut degré de précision près. Toutefois, l'obtention de $\Delta B/B$ de l'ordre de $10^{-6}$ ou mieux sur des volumes avoisinant 10 litres, nécessite un excellent alignement des éléments et/ou bobines qui créent le champ magnétique. Le prix d'aimants de haute résolution est, pour ces raisons techniques, très élevé (ex: un cryoaimant donnant un champ de 2,3 Teslas avec une inhomogénéité de $10^{-6}$ dans une sphère de 30 cm de diamètre coûte approximativement 1,5 MF). Or l'imagerie du proton (eau ~ 80 % du corps) ne pose pas de problème quant à la sensibilité, car les signaux protoniques sont très intenses et nombreux. Ainsi, une méthode d'imagerie en champ inhomogène ($\Delta B/B \simeq 10^{-4}$), qui s'affranchirait des distorsions dues à la non uniformité du champ magnétique de polarisation, peut s'envisager dans le cas du proton (imageurs médicaux essentiellement), sans grande perte au niveau de la sensibilité. Il en résulterait une substantielle économie sur le coût des aimants, donc le coût général de l'appareillage.

On signalera enfin pour mémoire, les méthodes qui consistent à dresser au préalable la carte E(x,y,z) du champ et à entrer les valeurs mesurées dans le calculateur qui construit l'image. Il est bien évident que ces méthodes sont peu satisfaisantes, car longues et délicates d'emploi, et par là-même, très coûteuses.

La présente invention a précisément pour objet un procédé de génération et de traitement de signaux pour l'obtention par RMN d'une image exempte de distorsions à partir d'un champ de polarisation inhomogène qui permet, à l'aide d'un simple doublement du nombre de mesures effectuées, de s'affranchir totalement des inhomogénéités du champ de polarisation, y compris de celles introduites par la présence du corps à imager, et qui fournit, de surcroit, comme sous-produit, la cartographie du champ de l'aimant de polarisation.

Ce procédé, qui utilise les méthodes connues de codage de l'image en deux ou trois dimensions (en terminologie anglosaxonne "2DFT" et "3DFT") comportant l'application d'une impulsion de radiofréquence à 90° dans le plan xOy, puis un codage de phase pendant un temps $\tau$ suivi d'un codage de fréquence par application selon Ox d'un gradient de lecture pendant l'acquisition du signal de précession libre, signal auquel on fait subir ensuite des transformations de Fourier par rapport au temps et par rapport au(x) gradient(s) appliqué(s) et que l'on recueille sous forme complexe, se caractérise par les étapes suivantes:

a) au cours d'une première série de séquences d'acquisition des signaux comportant un codage de phase et un codage de fréquence, on recueille de la façon connue précédente n signaux complexes $s_1(\tau,t)$ de précession libre;

b) au cours d'une deuxième série de séquences comportant l'application successive des mêmes gradients, on soumet le système en précession libre à une seconde impulsion de radiofréquence de 180° au début de l'établissement de chaque gradient de lecture, de façon à changer en $-Ø$ (ou $\pi - Ø$ selon le cas) les phases Ø acquises par les différents moments magnétiques durant le codage de phase et l'on recueille n signaux imaginaires $s_2(\tau, t)$, les étapes a) et b) précédentes pouvant être successives ou imbriquées dans le temps;

c) on forme les signaux $s^*_2(\tau,t)$ conjugués de $s_2(\tau,t)$ qui sont tels que $s^*_2(\tau,t) = s_1(\tau, -t)$, et on les associe un par un avec leur homologue $s_1(\tau,t)$ de façon à former n signaux complexes $s(\tau,t)$ dans lesquels t varie de -T à +T, T étant le temps d'acquisition de chaque signal compté à partir du début de l'application du gradient de lecture;

d) on effectue sur ces signaux $s(\tau,t)$ pour lesquels $-T < t < +T$, les transformées de Fourier par rapport au temps t et par rapport au(x) gradient(s) appliqué(s), ce qui fournit une image complexe multidimensionnelle dont les parties réelle R et imaginaire I ne comportent que des termes d'absorption pure;

e) on effectue sur chaque point x, y, z, les corrections de distorsion selon Ox et d'affectation d'intensité d'aimantation en calculant successivement la valeur correcte de la phase

$$Ø = \text{Arc cos} \frac{R}{\sqrt{R^2 + I^2}},$$

la fonction E(x,y,z) représentant la cartographie du champ par la relation

$$Ø(x,y,z) = \gamma E(x,y,z)\tau,$$

puis par la relation

$$Gx \cdot x + E(x,y,z) - Gx \cdot x' = 0,$$

la valeur x' de x à laquelle doit être affectée l'intensité d'aimantation trouvée.

Le fait de doubler le nombre des mesures effectuées par rapport aux méthodes connues jusqu'à ce jour en faisant précéder une fois sur deux l'établissement du gradient de lecture Gx d'une impulsion de 180 permet donc de définir un signal de résonancé qui évolue dans le temps de -T à +T et d'obtenir, après les deux transformées de Fourier, une image, certes distordue dans la direction du gradient de lecture, mais exempte de brouillage, c'est-à-dire dont les parties réelle R et imaginaire I selon la direction de ce même gradient de

lecture ne comportent que des termes d'absorption pure; ceci permet de corriger ensuite la distorsion, par calcul en chaque point de la phase exacte, de l'inhomogénéité E(x,y,z) du champ, puis enfin de la valeur exacte x' de l'ordonnée x à laquelle doit être attribuée l'intensité d'aimantation trouvée au point (x,y,z).

Dans les explications qui vont suivre, on raisonnera, pour plus de simplicité dans les exposés mathématiques, en imagerie bidimensionnelle (x,y) avec sélection de coupe selon Oz. Il doit être bien entendu toutefois que ceci n'est nullement limitatif du domaine d'application de l'invention et que la généralisation au cas d'une imagerie tridimensionnelle est tout à fait à la portée de l'homme de métier. Par ailleurs, le choix particulier qui est fait dans tout le présent texte des rôles particuliers des trois coordonnées x, y, z vis-à-vis du champ de polarisation et des directions des gradients appliqués résulte de la pratique internationale habituelle en ce domaine, mais ne saurait nullement constituer une limitation de portée du procédé objet de la présente invention.

On donnera maintenant l'explication mathématique de l'efficacité du procédé selon l'invention, en se référant aux Fig. 6 à 16 suivantes sur lesquelles.

- les Fig. 6 et 7 illustrent les deux séquences nécessaires, dans le cadre de l'invention, à la construction d'une image RMN par le procédé 2DFT avec sélection de tranche perpendiculaire à Oz;
- les Fig. 6a et 7a illustrent les deux séquences nécessaires dans le cadre de l'invention, à la construction d'une image RMN par le procédé 3DFT;
- les Fig. 8, 9 et 10 illustrent les distorsions de forme et d'intensité d'une image à deux dimensions dues à l'inhomogénéité du champ de polarisation Bo que l'invention permet de corriger;
- les Fig. 11 à 16 représentent les termes d'absorption et de dispersion du spectre complexe de l'image obtenue par transformée de Fourier dans différentes hypothèses envisagées.

Pour tenir compte de l'inhomogénéité du champ de polarisation, on écrira la valeur de ce champ sous la forme

$$B(x,y) = Bo + E(x,y),\ E(x,y)$$

représentant le défaut d'homogénéité ou carte du champ au point (x,y). Dans cette hypothèse, au cours de la première série de séquences d'acquisition de signaux sans impulsion de 180° (Fig. 6), on recueille les signaux:

$$s_1(t,\tau y) = \iint_{xy} M(x,y)\ e^{i\gamma Gy.y.\tau_y}.e^{i\gamma E(x,y)\,\tau_y}\,.\,.e^{i\gamma Gx.x.t}\,.e^{i\gamma E(x,y)\,t}dx.dy$$

formule dans laquelle on néglige par commodité l'amortissement $e^{-t/T_2}$ et la pulsation $e^{i\omega o t}$ du signal, ce qui est légitime pour ce dernier élément car on effectue une détection synchrone.

Dans cette formule, les deux premières exponentielles représentent les phases acquises par chaque vecteur aimantation M (x,y) pendant le codage de phase et dues respectivement à l'application du gradient Gy et au défaut d'homogénéité du champ E(x,y). Pour une valeur de y donnée, ces phases sont des constantes. Les deux dernières exponentielles représentent les phases, acquises par ces mêmes vecteurs M (x,y) pendant le temps t de lecture, et dues respectivement à l'application du gradient Gx et au défaut d'homogénéité du champ E(x,y). Ces phases dépendent du temps t et, pour la dernière, $i\gamma E(x,y)t$, à la fois de x et de y. C'est précisément ce terme qui, à cause de sa double dépendance de x et de y serait très gênant et "obscurcirait" l'image de façon irrécupérable si on en restait là.

Au cours de la deuxième série de séquences d'acquisition de signaux, représentée Fig. 7, on fait précéder l'application de chaque gradient de lecture Gx d'une deuxième impulsion de radiofréquence de 180° à la fréquence ωo, impulsion que l'on supposera, dans cette partie de la démonstration, en quadrature avec la première, c'est-à-dire selon l'axe Oy' de la Fig. 2. Il en résulte donc, conformément aux explications fournies dans l'introduction du présent texte, un changement de signe des phases Ø acquises par chaque vecteur aimantation $\vec{M}(x,y)$ pendant le codage de phase et les signaux $s_2(\tau_y,t)$ recueillis ont la forme générale:

$$s_2(t,\tau y) = \iint_{xy} M(x,y)e^{-i\gamma Gy.y.\tau_y}e^{-i\gamma E(x,y)\tau_y}.e^{i\gamma Gx.x.t}.e^{i\gamma E(x,y)t}dxdy$$

Si l'on forme maintenant les signaux imaginaires conjugués $s^*_2(t,\tau_y)$, ils s'écrivent sous la forme générale:

$$s_2^*(t,\tau_y) = \iint_{xy} M(x,y) e^{i\gamma Gy.y.\tau_y} e^{i\gamma E(x,y)\tau_y} . e^{-i\gamma Gx.x.t} . e^{-i\gamma E(x,y)t} dxdy$$

et l'on constate facilement l'égalité:

$s^*_2(t,\tau_y) = s_1(-t\tau_y)$

C'est là la caractéristique essentielle du procédé selon l'invention qui permet, en associant deux par deux les 2n signaux globaux reçus de 0 à +T de définir n signaux $s(t,\tau_y)$ dans lesquels t varie de -T à +T. Il suffit, pour ce faire, d'associer chaque signal $s_1(t,\tau_y)$ de la première séquence avec son homologue $s^*_2(t,\tau_y)$ de la seconde séquence obtenu après application d'une impulsion à 180° et conjugaison du signal.

C'est cette possibilité d'intégrer les signaux de $-\infty$ à $+\infty$ au cours des transformées de Fourier ou, plus exactement de -T à T, car l'infini n'existe pas pour le physicien, qui permet, bien que les signaux soient réellement lus de 0 à T, de supprimer le brouillage de l'image dont les composantes, grâce au procédé objet de l'invention, ne comportent plus que des termes d'absorption pure. Ce résultat découle d'un théorème de mathématiques connu, d'après lequel:

$\int_0^{+\infty} e^{-i\lambda x} dx = A(\lambda) + iB(\lambda)$,

λ paramètre quelconque, alors que

$\int_{-\infty}^{+\infty} e^{-i\lambda x} dx = A(\lambda)$,

A et B fonction de λ,

c'est-à-dire que l'intégration de $-\infty$ à $+\infty$ permet de supprimer la partie imaginaire du résultat de l'intégration. Cette propriété sera démontrée plus loin dans un cas particulier.

Les signaux $s_1(t,\tau_y)$ précédents, peuvent s'écrire également $s_1(G_y,t)$ puisqu'en fait, c'est, lors de chaque mesure $G_y$ qui varie, pendant le même temps $\tau_y$ de -G à +G. Dans ces conditions, la double transformée de Fourier par rapport à Gy et à t s'écrit:

$$A(yo,Gx.x') = \iint_{-\infty}^{+\infty} s\ (Gy,t) e^{-i\gamma Gy.yo.\tau} . e^{-i\gamma Gx.x't} dGy.dt$$

La première transformée de Fourier par rapport à Gy est égale à:

$$1/\tau \int_{-\infty}^{+\infty} M(x,yo) e^{i\gamma E(x,yo)\tau} . e^{i\gamma\{Gx.x+E(x,yo)-Gx.x'\}t} .dx$$

formule dans laquelle x' est l'abscisse corrigée de la distorsion à laquelle il faut attribuer l'intensité trouvée pour le point x,y.

La deuxième transformée de Fourier par rapport à t est égale à:

$$A(yo,\ Gx \cdot x') = \frac{1}{\tau \cdot \xi} \cdot M\ (xo,yo) e^{i\gamma E(xo,yo)\tau} \qquad (1)$$

formule qui donne finalement les deux tableaux de points (x,y) affectés de leur intensité M(x,y) constituant ce qu'il est convenu d'appeler les parties "réelle" et "imaginaire" de l'image complexe et dans laquelle xo et $\xi$ sont donnés par les équations:

$$Gx \cdot xo + E(xo,yo) - Gx \cdot x' = 0 \qquad (2)$$

et

$$\xi = \frac{\partial}{\partial x}[Gx \cdot x + E(x,yo) - Gx \cdot x']_{x = xo} \qquad (3)$$

Les couples de valeurs M, x et y donnés par l'équation (1) sont entachés d'une erreur systématique due à l'inhomogénéité E(x,y) qui se traduit par une distorsion de l'image selon la direction x du gradient de lecture. En d'autres termes, il est encore nécessaire pour corriger cette distorsion de l'image de chercher, pour une valeur donnée de y, la valeur x' exacte de x à laquelle on doit attribuer l'intensité d'aimantation M. Ceci est réalisé de la façon suivante.

La comparaison des parties réelle R et imaginaire I de l'équation (1) permet de calculer la phase Ø du signal au point x,y par exemple par la formule :

$$Ø = \text{Arc} \cos \frac{R}{\sqrt{R^2 + I^2}}$$

et la valeur de E(xo,yo). Cette valeur, reportée dans (2), permet de déduire xo car Gx et Gx · x' sont connus. Enfin, la connaissance de E(xo,yo) pour toute valeur de x permet de calculer ξ. On parvient ainsi finalement à la détermination de M(x,y) recherché et on obtient E(x,y) ou cartographie du champ à titre de sous-produit de la méthode.

On voit donc que c'est la possibilité d'effectuer les transformées de Fourier sur un signal qui varie de -T à +T qui permet, selon le procédé objet de l'invention, de construire une image corrigée de ses distorsions par calcul de la phase exacte en chaque point et de l'abscisse exacte x' pour chaque intensité M(x,y) mesurée. Par ailleurs, le fait que le procédé conduise à l'obtention, à titre de sous-produit, de la cartographie exacte du champ E(x,y) est aussi l'un des avantages majeurs de l'invention.

L'extension de ce qui précède à une imagerie à trois dimensions ne pose aucun problème de principe.

En effet, les séquences nécessaires à une telle imagerie RMN du type "3DFT" appliquant le procédé objet de l'invention sont représentées schématiquement sur les Fig. 6a (impulsion à 90° seule) et 7a (impulsions à 90° et à 180°) qui se lisent d'elles-mêmes par comparaison avec les Fig. 6 et 7. On voit simplement que les graphes 2 et 3 correspondent à des codages de phase selon Oy et Oz, les graphes 4 au codage de fréquence suivant Ox, les impulsions de radiofréquence (graphes 1 et 3') et la lecture (graphes 5) se déroulant comme dans l'exemple des Fig. 6 et 7.

Conformément à l'invention, les signaux obtenus à l'aide des deux séquences des Fig. 6a et 7a sont associés comme expliqué à propos de l'exemple des Fig. 6 et 7, de façon à définir un signal dans les intervalles [-T, +T], [$-G_z$, $+G_z$] et [$-G_y$, $+G_y$].

L'analyse mathématique du procédé mis en oeuvre est alors la suivante:

soit $\Delta(x,y,z) = \gamma E(x,y,z)$ l'écart de pulsation au point (x,y,z) par rapport à la valeur nominale de la pulsation; $\Delta(x,y,z)$ mesure donc l'inhomogénéité en (x,y,z).

Le signal recueilli est de la forme:

$$s(G_y, G_z, t) = \iiint_{xyz} dx\, dy\, dz\, M(x,y,z)\, e^{i\Delta(x,y,z)\tau}$$

$$e^{i\gamma G_y y\tau}\, e^{i\gamma G_z z\tau}\, e^{i\gamma G_x xt}\, e^{i\Delta(x,y,z)t}$$

Les trois transformations de Fourier classiques sont effectuées par rapport à $G_y$, $G_z$ et t dans un ordre indifférent.

Pour un signal S, ces transformations de Fourier sont:

- par rapport à $G_y$ :

$$\frac{1}{2\pi} \int_{-G_y}^{+G_y} S\, e^{-i\gamma G_y y_o \tau}\, dG_y$$

- par rapport à $G_z$ :

$$\frac{1}{2\pi} \int_{-G_z}^{+G_z} S\, e^{-i\gamma G_z z_o \tau}\, dG_z$$

- par rapport à t :

$$\frac{1}{2\pi} \int_{-T}^{+T} S\, e^{-ikt}\, dt$$

d'où le résultat

$$S(zo,yo,k) = \frac{1}{(2\pi)^3} \frac{1}{\gamma^2\tau^2\xi} M(x_o,y_o,z_o)e^{i\Delta(x_o,y_o,z_o)\tau}$$

où $x_o$ et $\xi$ sont donnés par l'équation :

$$\gamma G_x x_o + \Delta(x_o,y_o,z_o) - K = 0$$

$$\xi = \left| \frac{\partial}{\partial x}(\gamma G_x x + \Delta\ (x,y_o,z_o) - K) \right|_{x = x0} = 0$$

Dans ce cas, on obtient comme résultat des transformées de Fourier, une image complexe tridimensionnelle avec un volume "réel" et un volume "imaginaire" exempts de termes de dispersion, c'est-à-dire, en fait, à la sortie du calculateur, deux séries d'ensembles de quatre valeurs discrètes M, x, y, z correspondant aux différents points de ces deux volumes. Pour chacun des points de ces deux volumes, les valeurs z et y sont justes, mais celles de M et de x sont erronées en raison de la distorsion due à l'inhomogénéité E(x,y,z) du champ. Comme dans le cas de l'imagerie bidimensionnelle, on corrige ces erreurs de distorsion de l'image en calculant successivement pour chaque point:

- la phase correcte

$\emptyset = \text{Arc cos} \frac{R}{\sqrt{R^2 + I^2}}$,

R et I étant respectivement les parties réelle et imaginaire de l'image complexe selon la direction x;

- la fonction E(x,y,z) par la relation :

$\emptyset(x,y,z) = \gamma E(x,y,z)\tau$;

- la valeur x' de x à laquelle doit-être affectée l'intensité M(x,y,z) trouvée pour le point considéré, par la relation:

$Gx \cdot x + E(x,y,z) - Gx \cdot x' = 0$.

Il est utile, au stade actuel de l'exposé, de faire les remarques suivantes.

D'abord, le calcul précédent suppose que l'équation générale

$Gx \cdot x + E(x,y,z) - Gx \cdot x' = 0$

n'ait qu'une seule solution. Ceci est heureusement réalisé sans difficulté si Gx est suffisamment grand pour que $Gx \cdot x + E(x,y,z)$ soit une fonction monotone, ce qui est en pratique toujours réalisé.

Ensuite, les calculs précédents sont effectués dans la réalité sur des échantillonnages discrets des fonctions étudiées, puisque tous les signaux sont digitalisés pour traitement par l'ordinateur et le signal analytique complexe recueilli, qui résulte comme toujours en RMN d'une détection en quadrature (partie "réelle" ou "en cosinus" et partie "imaginaire" ou "en sinus") se compose en fait d'une double liste d'ensembles de points discrets. Ceci n'est pas un obstacle à l'exécution pratique des calculs formels exposés.

Enfin, selon une variante du procédé objet de l'invention, la seconde impulsion de radiofréquence de 180° est en phase avec la première appliquée au début du codage de phase et l'on obtient des signaux $s^*_2(\tau,t) = -s_1(\tau,-t)$, que l'on change de signe avant de les associer à leur homologue de la première séquence.

En effet, si la seconde impulsion de radiofréquence de 180° est appliquée, selon Ox' en phase avec la première de 90°, les phases acquises pendant le codage de phase se changent instantanément en $(\pi - \emptyset)$ comme expliqué sur la Fig. 2. Il en résulte que les exponentielles de l'expression $s_1(t,\tau)$ concernant la phase $\emptyset$ acquise pendant le codage de phase se transforment de $e^{i\emptyset}$ en $e^{i(\pi - \emptyset)} = -e^{-\emptyset}$. Il en résulte que, dans ce cas, $s^*_2(\tau,t) = -s_1(\tau,-t)$.

Il est donc nécessaire, dans ce cas, de changer de signe les signaux $s^*_2(\tau,t)$ avant de les associer à leur homologue de la première séquence pour calculer les intégrales de Fourier de -T à +T.

On donnera maintenant, à titre de précisions complémentaires sur le procédé objet de l'invention, un certain nombre d'explications et de justifications sur les raisons d'être et le mode de fonctionnement de ce procédé qui permettront, dans le cas particulier d'une image bidimensionnelle, de mieux comprendre les données théoriques qui ont été exposées jusqu'ici.

Pour l'image complexe calculée par l'ordinateur, l'inhomogénéité du champ Bo de polarisation conduit, aussi bien pour la partie réelle que pour la partie imaginaire à deux types de distorsions:

a) distorsion de forme (ex: une croix droite (Fig. 8) voit sa branche verticale devenir inclinée (Fig. 9), car les distorsions de forme se manifestent selon les directions Oy perpendiculaires à celles Ox du gradient de lecture Gx qui est horizontal);

b) distorsion d'intensité (ex: une région dont le niveau de gris est normalement uniforme, est alors striée de bandes alternativement plus intenses ou plus sombres, selon des directions perpendiculaires aux équipotentielles de champ magnétique, qui sont ici horizontales (Fig. 10) (cas d'un gradient résiduel selon Oy pour E(x,y)).

L'image imaginaire présente des distorsions de type a) et b) analogues.

Toutefois, la grande différence entre le procédé selon l'invention et l'art antérieur réside dans le fait que ces distorsions s'effectuent sans brouillage de l'information; ce sont des distorsions sans astigmatisme alors qu'en procédure usuelle elles sont astigmatiques, donc de véritables abréviations qu'il n'est pas possible de corriger (sauf si on connait au préalable la cartographie du champ et que l'on en tient compte dans le processus de construction de l'image). L'exposé qui suit permet de comprendre pourquoi.

Pour le comprendre, il est nécessaire de se rapporter aux propriétés particulières de la transformation de Fourier, transformations opérées sur des signaux dont l'amplitude décroît avec la valeur du paramètre d'acquisition.

En imagerie par 2DFT, il y a deux paramètres d'acquisition :

- le temps (s $\simeq$ o si |t| > Tm, Tm de l'ordre de T en raison de la relaxation transversale,
- le gradient Gy; si Gy est élevé, le déphasage des spins nucléaires est très rapide et le signal recueilli petit (s $\simeq$ o si |Gy| > Gm, Gm de l'ordre de G valeur maximale absolue du gradient de codage utilisé, $-G \leqslant Gy \leqslant +G$).

Gy occupe toujours un domaine comportant des valeurs positives et des valeurs négatives, en général opposées entre elles et qui correspondent toutes à ce qu'on appelle l'échantillonnage de la valeur du gradient.

Pour simplifier l'analyse, on considèrera la dépendance d'un signal par rapport au temps (par rapport à Gy le problème est absolument le même, donc un seul raisonnement suffit). Pour simplifier encore, considérons un signal "monochromatique", ce qui n'enlève aucune généralité au raisonnement puisque le signal reçu peut être considéré comme la superposition (l'addition) de signaux monochromatiques.

Le raisonnement portera donc sur un signal:

$$s(t) = a\, e^{-t/T_2}\, e^{j\omega o t},\ j = \sqrt{-1}$$

$T_2$ caractérise l'amortissement transverse du signal (en RMN on l'appelle temps de relaxation spin-spin apparent, et il gouverne la valeur de la largeur de raie).

La transformée de Fourier de s(t) (ou spectre complexe) est définie comme suit:

Si le signal est défini de 0 à $\infty$ (s(t) = 0 si t < 0),

$$S(\omega) = \int_{-\infty}^{+\infty} s(t)\, e^{-j\omega t}\, dt$$

On a : $$S(\omega) = \int_{-\infty}^{o} o + \int_{o}^{\infty} s(t)\, e^{-j\omega t}\, dt$$

$$S(\omega) = \int_{o}^{\infty} a\, e^{(-1/T_2 + j(\omega o - \omega)t}\, dt$$

$$S(\omega) = a\, \frac{1}{-1/T_2 + j(\omega o - \omega)} \left[ 0 - 1 \right]$$

$$S(\omega) = a\, \frac{-1(-1/T_2 - j(\omega o - \omega)}{(1/T_2)^2 + (\omega o - \omega)^2}$$

$$S(\omega) = a\, \frac{T_2}{1 + (\omega o - \omega)^2 T_2{}^2} + j\, a\, \frac{T_2{}^2(\omega o - \omega)}{1 + (\omega o - \omega)^2 T_2{}^2}$$

$$S(\omega) = Ro(\omega) + jIo(\omega)$$

Le spectre est complexe.

La partie réelle $Ro = \dfrac{aT_2}{1+(\omega o-\omega)^2 T_2{}^2}$

représente le terme d'absorption (notation usuelle en spectroscopie) représenté sur la Fig. 11;

La partie imaginaire représente le terme de dispersion:

$$Io = \frac{aT_2^2(\omega o - \omega)}{1 + (\omega o - \omega)^2 T^2}$$

représenté sur la Fig. 12.

Si le signal est défini de $-\infty$ à $+\infty$, on peut écrire:

$$S(\omega) = a \int_{-\infty}^{+\infty} e^{(-1/T_2+j(\omega o-\omega)t} dt,$$

mais ceci est faux, car il faut tenir compte du fait que si $t \to -\infty$ $s(t) \to 0$. Ceci conduit aux égalités suivantes:

$$S(\omega) = a \left\{ \int_{-\infty}^{0} e^{-|t|/T_2} e^{j(\omega o-\omega)t} dt + \int_{0}^{\infty} e^{(-1/T_2+j(\omega o-\omega)t} dt \right\}$$

$$S(\omega) = a \left\{ -\int_{0}^{-\infty} e^{-|t|/T_2} e^{j(\omega o-\omega)t} dt + \int_{0}^{\infty} e^{(-1/T_2+j(\omega o-\omega)t} dt \right\}$$

$$S(\omega) = a \left\{ -\int_{0}^{\infty} e^{-t/T_2} e^{-j(\omega o-\omega)t} (-dt) + \int_{0}^{\infty} e^{(-1/T_2+j(\omega o-\omega)t} dt \right\}$$

$$= a \left\{ \frac{(0-1)}{-1/T_2-j(\omega o-\omega)} + \frac{(0-1)}{-1/T_2+j(\omega o-\omega)} \right\}$$

$$S(\omega) = 2a \frac{T_2}{1+(\omega o-\omega)^2 T_2{}^2}$$

Le spectre est réel et ne comporte qu'un seul terme qui est un terme d'absorption égale à $2Ro(\omega)$. Dans le cas d'un champ inhomogène, il faut considérer un signal qui présente un argument supplémentaire Ø tel que:

$$s'(t) = s(t)\, e^{j\text{Ø}},$$

$e^{j\text{Ø}}$ étant une constante pour chaque spin.

Dans ce cas, cette phase Ø supplémentaire est celle qui est introduite par l'inhomogénéité du champ. En effet, si tous les noyaux ne voient pas le même champ B, ils précessionnent à des vitesses angulaires différentes de celles que leur imposent:

- le codage de phase Gy;
- le codage en fréquence Gx lors de la lecture.

Dans le cas idéal Ø est donc nul (pas d'inhomogénéités), dans le cas non idéal Ø est fonction de la position spatiale des spins.

La transformation de Fourier donne

$$S'(\omega) = S(\omega)e^{j\text{Ø}}$$

au lieu de $S(\omega)$ étudié précédemment.

$\alpha$) si le signal n'est défini que de 0 à $+\infty$

$e^{j\text{Ø}} = \cos \text{Ø} + j \sin \text{Ø}$ et

$$S'(\omega) = (Ro(\omega) + j\, Io(\omega))(\cos \text{Ø} + j \sin \text{Ø}) = Ro(\omega) \cos \text{Ø} - Io(\omega) \sin \text{Ø} + j\,[Ro(\omega) \sin \text{Ø} + Io(\omega) \cos \text{Ø}]$$

On constate que la partie réelle et la partie imaginaire sont des combinaisons linéaires des termes d'absorption et de dispersion représentées sur les fig. 13 et 14 sur lesquelles:

$R(\omega) = Ro(\omega) \cos Ø - Io(\omega) \sin Ø$ et

$I(\omega) = Ro(\omega) \sin Ø + Io(\omega) \cos Ø$

Le spectre est donc obscurci par la présence de ces mèlanges et il en résulte une perte notable de la résolution, c'est-à-dire un brouillage irrécupérable de ces images.

β) si le signal est défini de $-\infty$ à $+\infty$

$S'(\omega) = 2Ro \cos Ø + j2Ro \sin Ø$

c'est-à-dire que les parties imaginaire $I = 2Ro \sin Ø$ et réelle $R = 2Ro \cos Ø$ sont des termes d'absorption purs modulés par cos Ø et sin Ø (voir Fig. 15 et 16).

La valeur de Ø n'a donc pas besoin d'être connue pour que l'on effectue une correction de phase, car connaissant R et I, on en déduit:

$Ø = \arc\cos \frac{R}{\sqrt{R^2 + I^2}}$

ce qui, dans le procédé de l'invention, revient à déterminer l'inhomogénéité de B en chaque point.

Ces résultats mathématiques s'appliquent immédiatement au procédé d'obtention d'images RMN correctes en champ inhomogène comme expliqué maintenant.

La variation de phase Ø(x,y) qui sera corrigée apparaît au cours de la période de codage de phase par le gradient Gy et s'écrit:

$Ø(x,y) = \gamma E(x,y)\tau$

où E(x,y) est l'"erreur" sur B au point x,y et τ la durée d'application du gradient Gy.

De plus, pendant la période de lecture (O-t), il apparaît un glissement de fréquence $\gamma E(x,y)/2\pi$ qui dépend malheureusement à la fois de x et de y pour le point (x,y) par rapport à la valeur observable en champ parfaitement uniforme. La phase (généralisée) acquise pendant Gx due à l'inhomogénéité E(x,y) est $\gamma E(x,y)t$, et à chaque instant, introduit donc:

i) si l'acquisition a lieu de 0 à $\infty$, un mélange des termes d'absorption et des termes de dispersion qui est irrécupérable si on ne connaît pas E(x,y) à l'avance et ceci dans les parties réelle et imaginaire des transformées de Fourier par rapport au temps.

ii) si l'acquisition a lieu de $-\infty$ à $+\infty$, une partie réelle et une partie imaginaire débarrassées des termes de dispersion, et qui permettent de déterminer l'écart par rapport à la valeur nominale de B en tout point x,y. Toutefois, le glissement en fréquences persiste, ce qui explique que les images sont déformées selon la direction ox du gradient de lecture. Aussi, faudra-t-il opérer en deux temps pour effectuer la correction.

On construit tout d'abord l'image, tout en conservant les deux informations: réelle et imaginaire. On dispose ainsi de l'image réelle et de l'image imaginaire. Seule la direction x est affectée par des distorsions de forme, sur chaque image.

1) Repérons un point (x,y) sur cette image complexe. En ce point, la comparaison des valeurs fournies par l'image réelle (R) et l'image imaginaire (I) donne: E(x,y) par la relation:

$\gamma E(x,y)\tau = \arc\cos \frac{R}{\sqrt{R^2 + I^2}}$

et l'intensité en ce point est $\sqrt{R^2 + I^2} = Ro$

2) La position y est correcte, mais non la position x qui est x', tel que:

$G_x x + E(x,y) - G_x x' = 0$

où x' est la valeur de l'abscisse à laquelle il faudra affecter l'intensité Ro. Cette intensité est donc affectée définitivement au couple (x',y) et la forme correcte de l'image, avec son signal image correct, est restituée.

Quelques remarques ou explications complémentaires seront données pour terminer l'exposé de l'invention et de ses principales applications.

a) Le procédé de l'invention demande un temps d'exposition double du temps que nécessiterait l'imagerie ordinaire. Cela peut être considéré comme un inconvénient, qui semble relativement mineur en comparaison du progrès apporté dans la qualité de l'image.

b) La valeur de l'erreur E(x,y,z), ou inhomogénéité, est déterminée par la méthode de restitution et non par une cartographie préalable. C'est un "sous-produit" du procédé et il peut avoir son utilité si l'on cherche à déterminer l'inhomogénéité introduite par la présence de l'échantillon. Par exemple, en imagerie RMN microscopique (objets inférieurs à 1 mm), on peut ainsi observer (tout en s'en débarrassant) les déformations des lignes du champ magnétique provoquées par la distribution de domaines dont les susceptibilités

diamagnétiques sont différentes. On en déduit une méthode d'imagerie de la répartition des susceptibilites diamagnétiques; en outre, le procédé de l'invention évite de recourir à des valeurs de gradients très importantes dans les techniques de microscopie, valeurs justement imposées actuellement pour atténuer l'hétérogénéité des objets observés.

c) Un petit inconvénient persiste: le fait que le déphasage soit défini à $2\pi$ près, si bien que la connaissance de E s'effectue modulo Eo, où $\gamma Eo\tau = 2\pi$. Toutefois, par continuité, il est pratiquement toujours possible de déterminer la valeur correcte de E.

d) Il est de plus, possible, d'opérer en présence de gradients non constants, à condition que la variation spatiale du champ imposée par le gradient soit monotone (c'est-à-dire si elle ne crée pas de dédoublements de la valeur du champ lors de leur utilisation). En effet, appliquer un gradient non constant revient à superposer une inhomogénéité supplémentaire E'(x,y). Cependant, la détermination correcte de E(x,y) à partir de la valeur obtenue Eo(x,y) = E(x,y) + E'(x,y) impose la connaissance de E'(x,y).

e) Le procédé s'applique également à toute opération d'imagerie effectuée dans un champ considéré comme "uniforme" par les constructeurs.

$\Delta B/Bo$ étant donné par le constructeur, la limite de résolution spatiale dans l'image peut être estimée égale à $\Delta 1 = \Delta B/G$ où G est la valeur absolue du gradient de lecture utilisée (Gx). Ainsi, il semble possible de reculer la limite de résolution spatiale accessible couramment dans le plan de l'image à une valeur nettement inférieure sans utiliser des valeurs de gradient nettement plus élevées que celles qui sont employées. Il en résulte une nette amélioration dans la manière d'appliquer ces gradients: alimentations en courant plus faibles, consommation électrique réduite.

Enfin, le procédé selon l'invention s'applique à des nombreux types d'imageries RMN, notamment:
- les imageries 2DFT et 3DFT;
- l'imagerie microscopique;
- les séquences "saturation-récupération",

inversion récupération, spin écho, lés séquences spécifiques à l'ètude des mouvements liquidiens et les séquences réalisant le contraste eau/graisses en imagerie des protons sur échantillons biologiques.

## Revendications

1. Procédé de génération et de traitement de signaux pour l'obtention d'une image de résonance magnétique nucléaire (RMN) exempte de distorsions à partir d'un champ de polarisation inhomogène $B = Bo + E(x,y,z)$, utilisant les méthodes connues de codage de l'image en deux ou trois dimensions (en terminologie anglosaxonne "2DFT" et "3DFT") comportant l'application d'une impulsion de radiofréquence à 90° dans le plan xOy, puis un codage de phase pendant un temps $\tau$ suivi d'un codage de fréquence par application selon Ox d'un gradient de lecture pendant l'acquisition du signal de précession libre, signal auquel on fait subir ensuite des transformations de Fourier par rapport au temps et par rapport au(x) gradient(s) appliqué(s) et que l'on recueille sous forme complexe, caractérisé par les étapes suivantes:

a) au cours d'une première série de séquences d'acquisition des signaux comportant un codage de phase et un codage de fréquence, on recueille de la façon connue précédente n signaux complexes $s_1(\tau,t)$ de précession libre;

b) au cours d'une deuxième série de séquences comportant l'application successive des mêmes gradients, on soumet le système en précession libre à une seconde impulsion de radiofréquence de 180° au début de l'établissement de chaque gradient de lecture, de façon à changer en -Ø (ou $\pi$ selon le cas) les phases $\pi$ acquises par les différents moments magnétiques durant le codage de phase et l'on recueille n signaux imaginaires $s_2(\tau,t)$, les étapes a) et b) précédentes pouvant être successives ou imbriquées dans le temps;

c) on forme les signaux $s_2^*(\tau,t)$ conjugués de $s_2(\tau,t)$ qui sont tels que $s_2^*(\tau,t) = s_1(\tau,-t)$, et on les associe un par un avec leur homologue $s_1(\tau,t)$ de façon à former n signaux complexes $s(\tau,t)$ dans lesquels t varie de -T à +T, T étant le temps d'acquisition de chaque signal compté à partir du début de l'application du gradient de lecture;

d) on effectue sur ces signaux $s(\tau,t)$, pour lesquels $-T < t < +T$, les transformées de Fourier par rapport au temps t et par rapport au(x) gradient(s) appliqué(s), ce qui fournit une image complexe multidimensionnelle dont les parties rèelle R et imaginaire I selon la direction x ne comportent que des termes d'absorption pure;

e) on effectue sur chaque point x, y, z, les corrections de distorsion selon Ox et d'affectation d'intensite d'aimantation en calculant successivement la valeur correcte de la phase:

$$Ø = \text{Arc cos} \frac{R}{\sqrt{R^2 + I^2}},$$

la fonction E(x,y,z) représentant la cartographie du champ par la relation $Ø(x,y,z) = \gamma E(x,y,z)\tau$ puis par la relation $Gx \cdot x + E(x,y,z) - Gx \cdot x' = 0$, la valeur x' de x à laquelle doit être affectee l'intensité d'aimantation trouvée.

2. Procédé d'obtention et de traitement de signaux selon la revendication 1, caractérisé en ce que la seconde impulsion de radiofréquence de 180° est en quadrature avec la première appliquée au début du codage de phase et l'on obtient des signaux $s^*_2(\tau,t) = s_1(\tau, -t)$.

3. Procédé d'obtention et de traitement de signaux selon la revendication 1, caractérisé en ce que la seconde impulsion de radiofréquencé de 180° est en phase avec la première appliquée au début du codage de phase et l'on obtient des signaux $s^*_2(\tau,t) = - s_1(\tau, -t)$, que l'on charge de signe avant de les associer à leur homologue de la première séquence.

**Patentansprüche**

1. Verfahren zur Erzeugung und Verarbeitung von Signalen zur Erzielung eines magnetischen Kernresonanzbildes (RMN), das frei von Störungen ist, anhand eines inhomogen polarisierten Feldes $B = Bo + E(x,y,z)$ unter Verwendung bekannter Verfahren zur Kodierung des Bildes in zwei oder drei Dimensionen (in angelsächsischer Terminologie "2DFT" und "3DFT"), umfassend die Zuführung eines H-Impulses unter 90° in der Ebene xOy, die anschließende Phasenkodierung während einer Zeit $\tau$ gefolgt von einer Frequenzkodierung durch Anwendung eines Lesegradienten gemäß Ox während der Erfassung des Signals freier Präzession, welches Signal man anschließend Fourier-Transformationen gegenüber der Zeit und gegenüber einem oder mehreren angewendeten Gradienten unterwirft und das man in komplexer Form wieder aufnimmt, gekennzeichnet durch die folgenden Schritte:

a) im Verlaufe einer ersten Serie von Erfassungsfolgen von Signalen, die eine Phasenkodierung und eine Frequenzkodierung aufweisen, nimmt man in der vorbekannten Art n komplexe Signale $s_1(\tau,t)$ freier Präzession auf;

b) im Verlaufe einer zweiten Folgeserie, die die aufeinanderfolgende Anwendung der gleichen Gradienten umfaßt, unterwirft man das System freier Präzession einem zweiten HF-Impuls von 180° zu Beginn der Einrichtung eines jeden Lesegradienten, um die Phasen Ø, die durch die unterschiedlichen magnetischen Momente während der Phasenkodierung erfaßt werden, in -Ø (oder $\pi$ - Ø, je nach Fall) zu ändern, und daß man n imaginäre Signale $s_2(\tau,t)$ wieder aufnimmt, wobei die vorstehenden Schritte a) und b) aufeinanderfolgend oder zeitlich verschachtelt sein können;

c) man bildet die konjugierten Signale $s_2^*(\tau,t)$ von $s_2(\tau,t)$, die so sind, daß $s_2^*(\tau,t) = s_1(\tau, -t)$, und man ordnet sie einzeln ihrem Homologen $s_1(\tau,t)$ zu, um n komplexe Signale $s(\tau,t)$ zu bilden, in denen t zwischen -T und +T variiert, wobei T die Erfassungszeit eines jeden Signals, gerechnet ab dem Beginn der Anwendung des Lesegradienten, ist;

d) man führt an diesen Signalen $s(\tau,t)$, für die $-T < t < +T$ ist, die Fourier-Transformationen gegenüber der Zeit t und gegenüber dem oder den angewendeten Gradienten aus, was ein komplexes mehrdimensionales Bild liefert, von dem der Realanteil R und der Imaginäranteil I gemäß der Richtung x nur reine Absorptionsterme enthalten;

e) man führt an jedem Punkt x, y, z die Störkorrekturen gemäß Ox und die Korrektur der Magnetisierungsintensitätsbeeinflussung aus, indem aufeinanderfolgend der richtige Phasenwert berechnet wird:

$$Ø = \text{Arc cos} \frac{R}{\sqrt{R^2 + I^2}},$$

wobei die Funktion $E(x,y,z)$ die Kartographie des Feldes durch die Beziehung $Ø(x,y,z) = \gamma E(x,y,z)\tau$, dann durch die Beziehung $Gx \cdot x + E(x,y,z) - Gx \cdot x' = 0$ darstellt, der Wert x' von x, bei dem die gefundene Magnetisierungsintensität beeinflußt werden muß.

2. Verfahren zur Erzielung und zur Verarbeitung von Signalen nach Anspruch 1, dadurch gekennzeichnet, daß der zweite HF-Impuls von 180° senkrecht zum am Anfang der Phasenkodierung zuerst angewendeten steht, und daß man Signale $s_2^*(\tau,t) = s_1(\tau, -t)$ erhält.

3. Verfahren zur Erzielung und zur Verarbeitung von Signalen nach Anspruch 1, dadurch gekennzeichnet, daß der zweite HF-Impuls von 180° in Phase mit dem zu Beginn der Phasenkodierung angewendeten ersten ist, und daß man Signale $s_2^*(\tau,t) = -s_1(\tau, -t)$ erhält, daß man das Vorzeichen ändert, bevor man sie ihrem Homolog der ersten Folge zuordnet.

**Claims**

1. Process for the generation and processing of signals for obtaining a nuclear magnetic resonance image, which is free from distortions on the basis of an inhomogeneous polarization field $B = Bo + E(x,y,z)$, using the known methods of coding the image in two or three dimensions (2D,FT and 3D,FT) involving the application of a 90° radiofrequency pulse in the xOy plane, then phase coding for a time $\tau$ followed by frequency coding by applying along Ox a reading gradient during the acquisition of the free precession signal, which then undergoes Fourier transformations relative to time and relative to the gradient or gradients applied and which is collected in complex form, characterized by the following stages:

a) during a first series of signal acquisition sequences involving phase coding and frequency coding, the complex free precession signals $s_1(\tau,t)$ are collected in the known manner;

b) during a second series of sequences involving the successive application of the same gradients, the free precession system is subject to a second 180° radiofrequency pulse at the start of establishing each reading gradient, so as to change to -Ø (or π-Ø as a function of the particular case) the Ø phases acquired by the different magnetic moments during phase coding and the n imaginary signals $s_2(\tau,t)$ are collected, stages a) and b) being either successive or interleaved in time;

c) the conjugate signals $s_2^*(\tau,t)$ of $s_2(\tau,t)$ are formed, which are such that $s_2(\tau,t) = s_1(\tau, -t)$, and they are associated one by one with their homolog $s_1(\tau,t)$ so as to form n complex signals $s(\tau,t)$ in which t varies from -T to +T, T being the acquisition time of each signal counted from the start of applying the reading gradient;

d) the Fourier transforms with respect to time t and with respect to the gradient or gradients applied are performed on these signals $s(\tau,t)$ for which $-T < t < +T$, which supplies a multidimensional complex image, whose real and imaginary parts R, I respectively only have pure absorption terms;

e) on each point x, y, z are performed distortion corrections along Ox and magnetization intensities are allocated by successively calculating the correct value of the phase

$$Ø = \text{Arc} \cos \frac{R}{\sqrt{R^2 + I^2}}$$

the function E(x,y,z) representing the cartography of the field by the relation $Ø(x,y,z) = \gamma E(x,y,z)\tau$, then by the relation $Gx \cdot x + E(x,y,z) - Gx \cdot x' = 0$, the value x' of x to which is to be allocated the magnetization intensity found.

2. Process for obtaining and processing signals according to claim 1, characterized in t at the second 100° radiofrequency pulse is in quadrature with the first pulse applied at the start of phase coding and the following signals are obtained: $s_2^*(\tau,t) = s_1(\tau, -t)$.

3. Process for obtaining and processing signals according to claim 1, characterized in that the second 180° radiofrequency pulse is in phase with the first pulse applied at the start of phase coding and the following signals are obtained $s_2^*(\tau,t) = -s_1(\tau, -t)$, whereby the sign thereof is changed before associating them with their homolog of the first sequence.

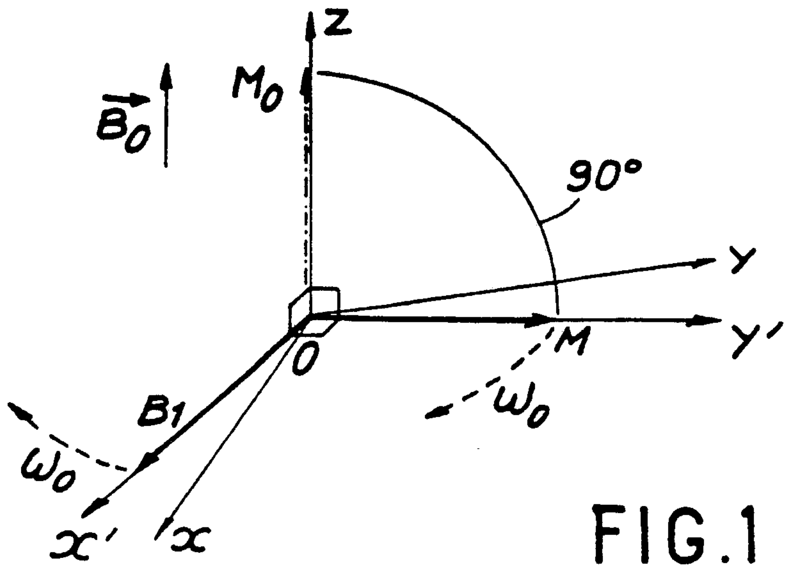


FIG.1

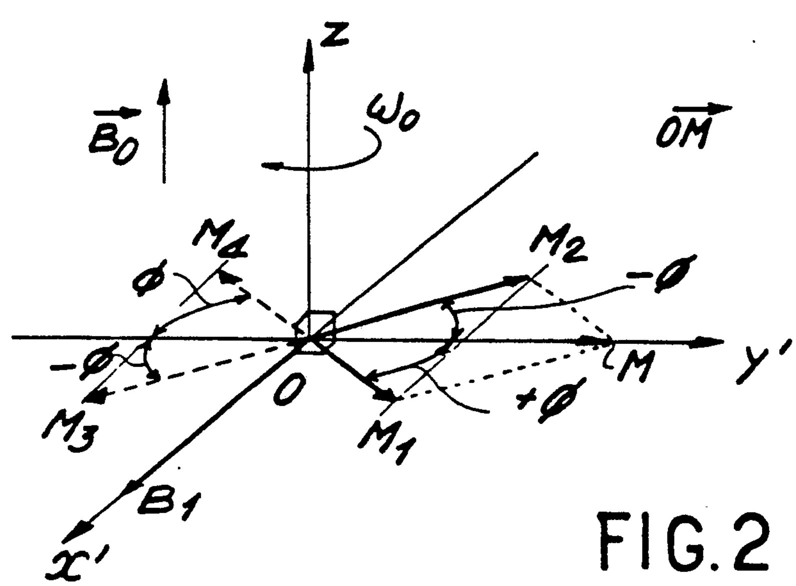


FIG.2

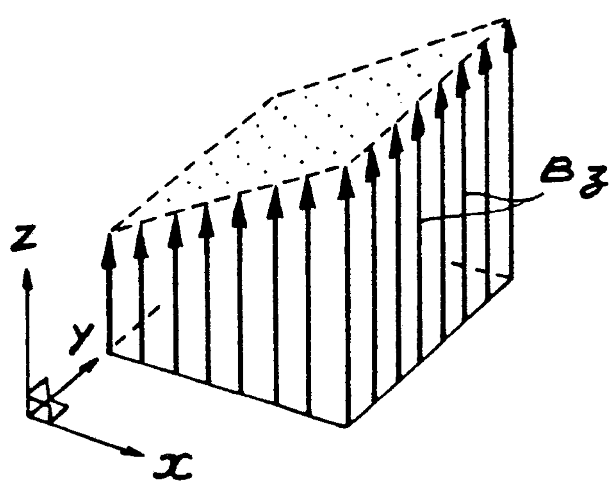


FIG.3

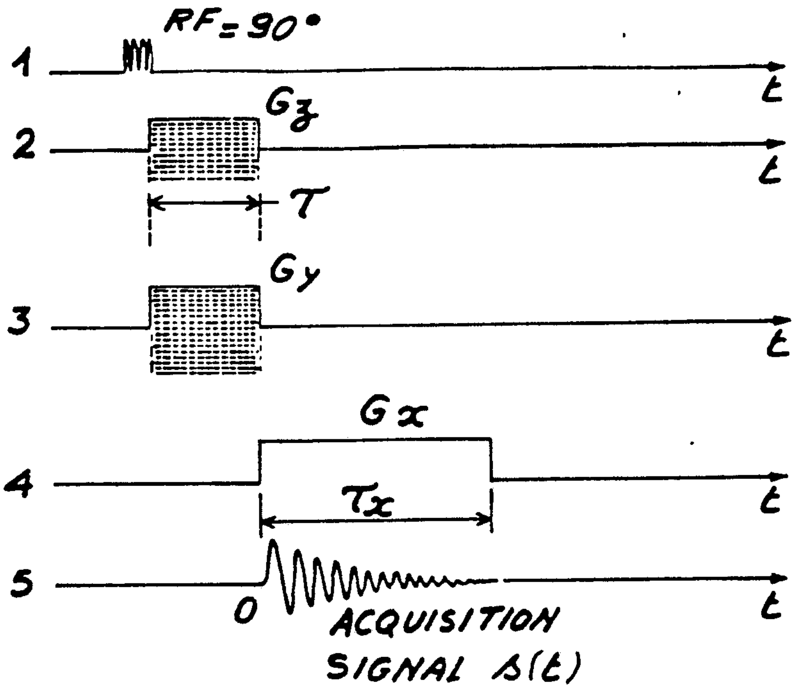
RF = 90°
1
2
3
4
5
Gz
τ
Gy
Gx
τx
t
0
ACQUISITION
SIGNAL s(t)

FIG. 4

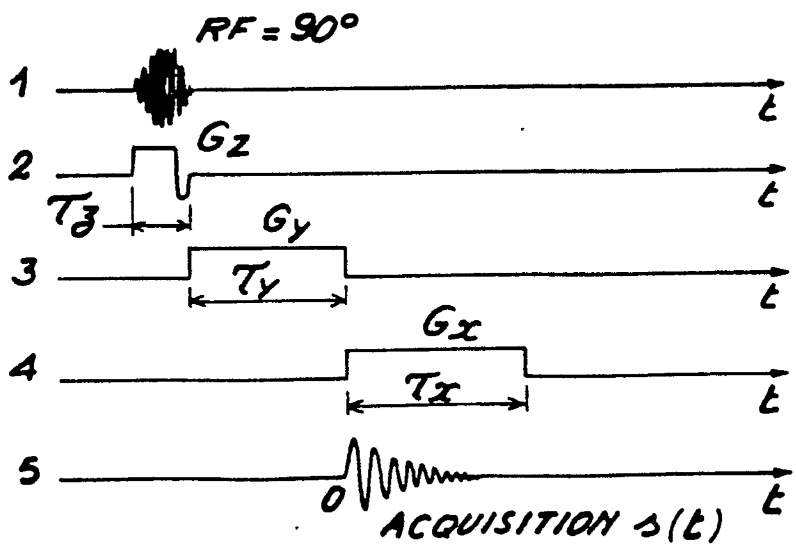
RF = 90°
1
2
3
4
5
Gz
τz
Gy
τy
Gx
τx
t
0
ACQUISITION s(t)

FIG. 5

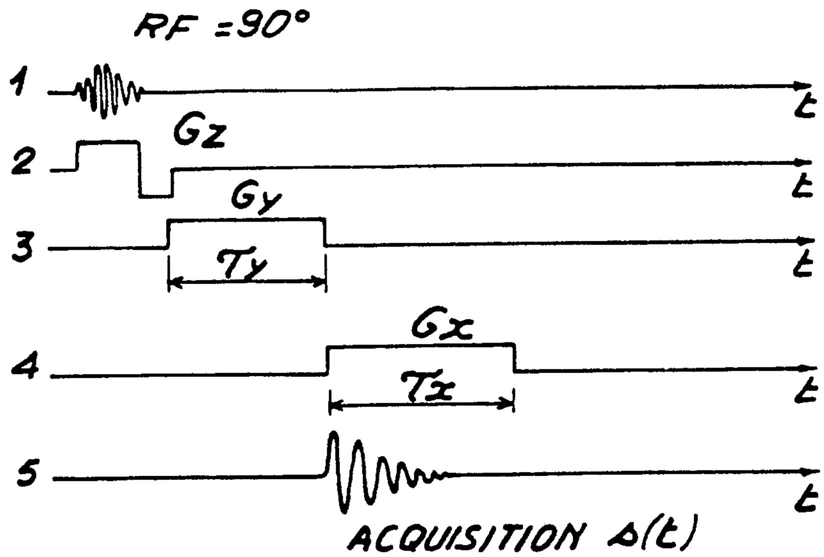
RF =90°
1
t
Gz
2
t
Gy
3
Ty
t
Gx
4
Tx
t
5
t
ACQUISITION s(t)

FIG.6

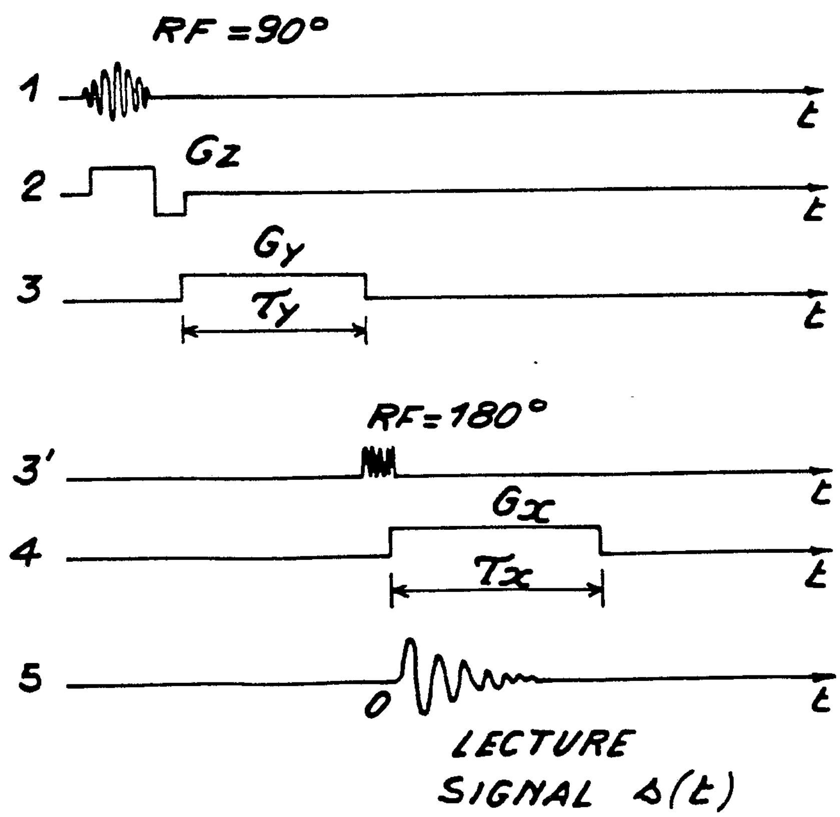
RF =90°
1
t
Gz
2
t
Gy
3
Ty
t
RF=180°
3'
t
Gx
4
Tx
t
5
0
t
LECTURE
SIGNAL s(t)

FIG.7

FIG. 6a

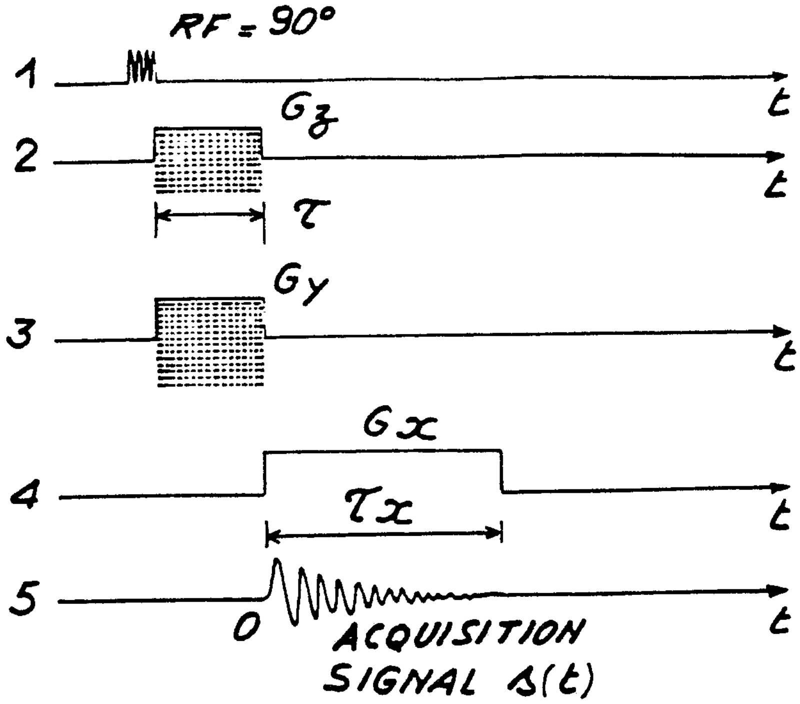
RF = 90°
1
t
Gz
2
t
τ
Gy
3
t
Gx
4
τx
t
5
0
ACQUISITION
SIGNAL s(t)
t

FIG. 7a

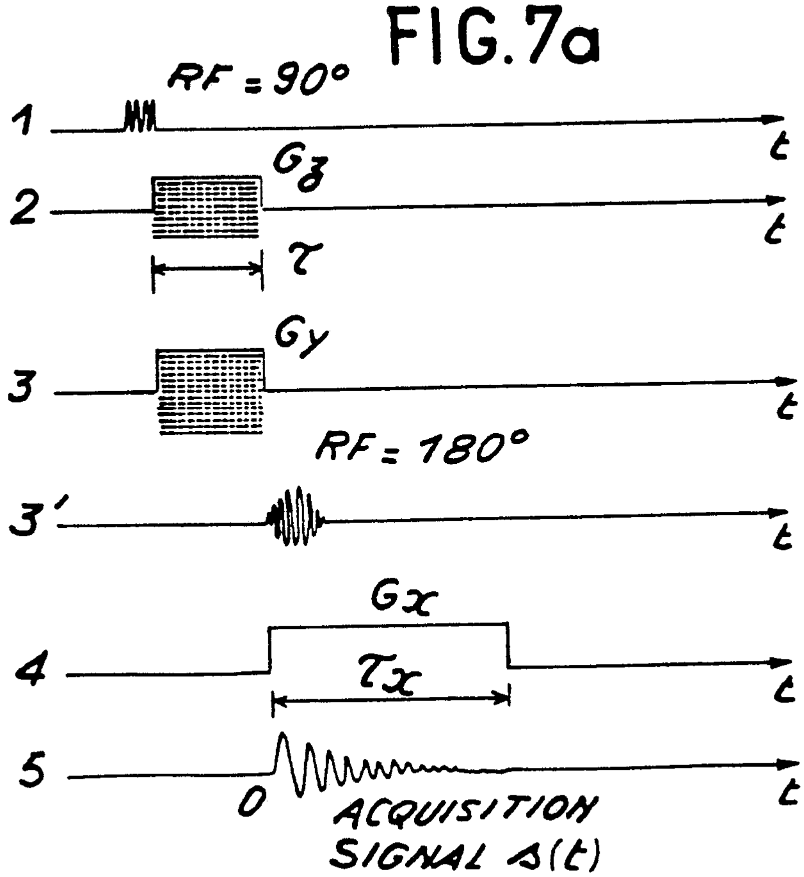
RF = 90°
1
t
Gz
2
t
τ
Gy
3
t
RF = 180°
3'
t
Gx
4
τx
t
5
0
ACQUISITION
SIGNAL s(t)
t

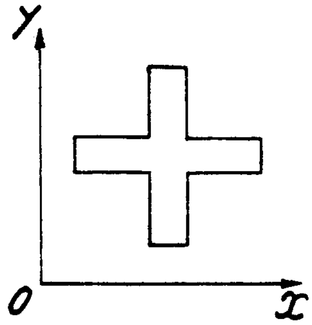


FIG.8

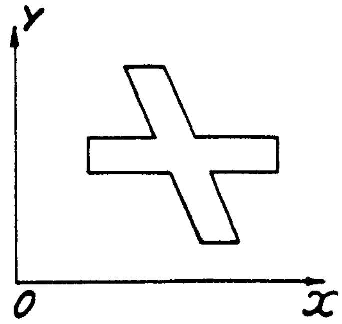


FIG.9

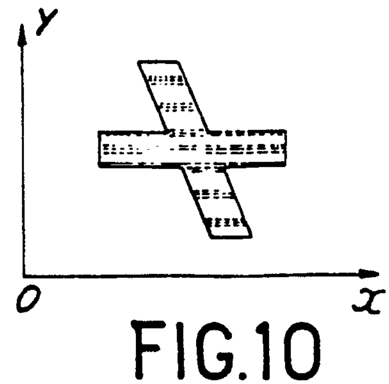


FIG.10

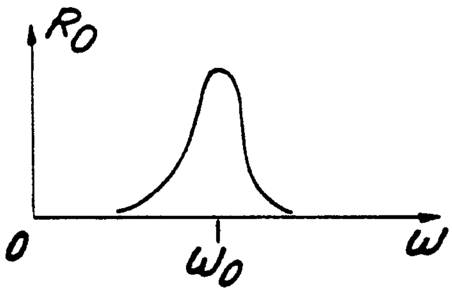


FIG.11

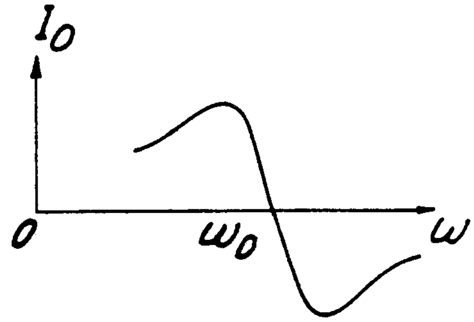


FIG.12

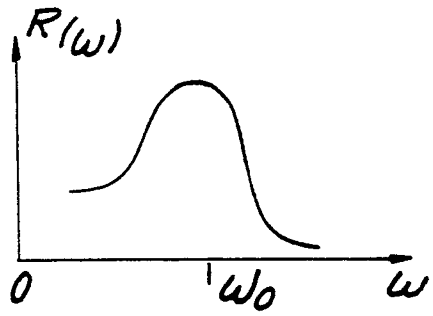


FIG.13

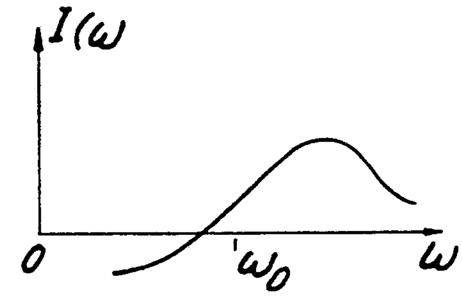


FIG.14

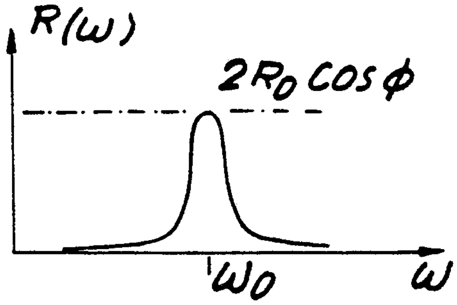


FIG.15

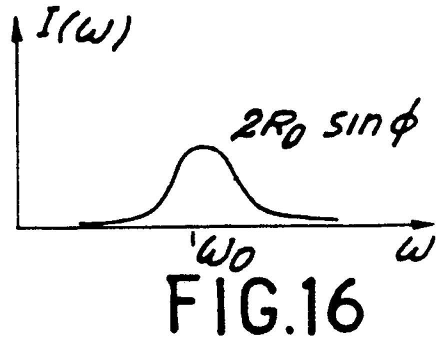


FIG.16